# EUROPEAN PATENT APPLICATION

(11) **EP 4 841 398 A1**
(43) Date of publication of application: **18.11.2026**
(21) Application number: 25752462.9
(22) Date of filing: 07.02.2025
(51) Int. Cl.: G06F 3/01, H02N 2/00, H02N 2/02, G06F 3/02, B06B 1/06

(54) **PIEZO ACTUATOR AND ELECTRONIC DEVICE COMPRISING SAME**

(30) Priority: 07.02.2024 KR 20240019077; 20.03.2024 KR 20240038418
(71) Applicant: Samsung Electronics Co., Ltd., Suwon-si, Gyeonggi-do 16677 (KR)
(72) Inventor: KIM, Taesik, Suwon-si, Gyeonggi-do 16677 (KR); JANG, Hyunsoo, Suwon-si, Gyeonggi-do 16677 (KR); BAEK, Kunwoo, Suwon-si, Gyeonggi-do 16677 (KR); SONG, Yongjae, Suwon-si, Gyeonggi-do 16677 (KR); CHO, Chihyun, Suwon-si, Gyeonggi-do 16677 (KR)
(74) Representative: HGF
(86) International application number: PCT/KR2025/001809
(87) International publication number: WO 2025/170352

(57) **Abstract**

According to one embodiment disclosed herein, an electronic device may comprise: a housing including one surface; a button coupled to the one surface to be movable with respect to the one surface and separated from the one surface; a first piezo actuator disposed inside the button; a second piezo actuator disposed inside the button and spaced apart from the first piezo actuator; a first holder coupled to the first piezo actuator and the second piezo actuator; and a support portion at least partially disposed between the button and the first holder. Various other embodiments may be possible.

## Description

### [Technical Field]

Embodiments disclosed in the present document relate to an electronic device, and for example, to a piezo actuator and an electronic device including the same.

### [Background Art]

Owing to the remarkable development of information communication technology and semiconductor technology, the distribution and use of various electronic devices is rapidly increasing. Electronic devices are being developed to be portable and capable of communication.

An electronic device may refer to a device that performs a specific function according to a program installed therein, such as a home appliance, an electronic notebook, a portable multimedia player, a mobile communication terminal, a tablet PC, a video/audio device, a desktop/laptop computer, or a vehicle navigation device. For example, such electronic devices may output stored information as sound or an image. As the degree of integration of an electronic device increases and high-speed, large-capacity wireless communication becomes commonplace, various functions may be mounted in a single electronic device such as a mobile communication terminal. For example, not only a communication function but also an entertainment function such as a game, a multimedia function such as music/video playback, a communication and security function such as mobile banking, or a schedule management or electronic wallet function are being integrated into a single electronic device. Such an electronic device is being downsized to be conveniently carried by a user.

The above-described information may be provided as related art for the purpose of helping understanding of the disclosure. No assertion or determination is raised as to whether any of the foregoing may be applicable as prior art in connection with the disclosure.

### [Detailed Description of the Invention]

### [Technical Solution]

According to an embodiment of the disclosure, an electronic device may include a housing including one surface, a button movably coupled to the one surface with respect to the one surface and separated from the one surface, a first piezo actuator disposed inside the button, a second piezo actuator disposed inside the button and spaced apart from the first piezo actuator, a first holder coupled to the first piezo actuator and the second piezo actuator, a second holder coupled to the first piezo actuator and a portion of the housing, a third holder coupled to the second piezo actuator and another portion of the housing, and a support portion disposed at least partially between the button and the first holder, the support portion configured to support at least a portion of the button corresponding to the support portion.

According to an embodiment of the disclosure, a key input device may include a button, a first piezo actuator disposed inside the button, a second piezo actuator disposed inside the button and spaced apart from the first piezo actuator, a first holder coupled to the first piezo actuator and the second piezo actuator, a second holder coupled to the first piezo actuator, a third holder coupled to the second piezo actuator, and a support portion disposed at least partially between the button and the first holder, the support portion configured to support at least a portion of the button corresponding to the support portion.

According to an embodiment of the disclosure, an electronic device may include a housing including one surface, a button movably coupled to the one surface with respect to the one surface and separated from the one surface, a plurality of piezo actuators disposed inside the button, a first holder disposed between the plurality of piezo actuators, and a support portion disposed at least partially between the button and the first holder. The number of the plurality of piezo actuators may be greater than the number of the buttons.

According to an embodiment of the disclosure, a key input device may include a button, a plurality of piezo actuators disposed inside the button, a first holder disposed between the plurality of piezo actuators, and a support portion disposed at least partially between the button and the first holder. The number of the plurality of piezo actuators may be greater than the number of the buttons.

### [Brief Description of Drawings]

In relation to the description of the drawings, the same or similar reference numerals may be used for the same or similar components.
FIG. 1 is a block diagram illustrating an electronic device in a network environment according to various embodiments.
FIG. 2 is a perspective view illustrating a front surface of an electronic device according to an embodiment of the disclosure.
FIG. 3 is a perspective view illustrating a rear surface of an electronic device according to an embodiment of the disclosure.
FIG. 4 is an exploded perspective view illustrating a front surface of an electronic device according to an embodiment of the disclosure.
FIG. 5 is an exploded perspective view illustrating a rear surface of an electronic device according to an embodiment of the disclosure.
FIG. 6 is a cross-sectional view illustrating an electronic device including a piezo actuator according to an embodiment of the disclosure.
FIG. 7 is a cross-sectional view illustrating an electronic device including a piezo actuator according to an embodiment of the disclosure.
FIG. 8 is a cross-sectional view illustrating an electronic device including a piezo actuator according to an embodiment of the disclosure.
FIG. 9 is a cross-sectional view illustrating an electronic device including a piezo actuator according to an embodiment of the disclosure.
FIGS. 10, 11, and 12 are cross-sectional views for describing an input sensor of a key input device according to an embodiment of the disclosure.
FIG. 13A is a view illustrating a state before a key input device is assembled to a housing according to an embodiment of the disclosure.
FIG. 13B is a view illustrating a state after a key input device is assembled to a housing according to an embodiment of the disclosure.
FIG. 14 is a cross-sectional view taken along line A-A' of FIG. 13B according to an embodiment of the disclosure.

### [Mode for Carrying out the Invention]

Hereinafter, embodiments of the disclosure will be described in detail with reference to the drawings so that those skilled in the art may easily implement the disclosure. However, the disclosure may be implemented in various different forms and is not limited to the embodiments described herein. In relation to the description of the drawings, the same or similar reference numerals may be used for the same or similar components. Further, in the drawings and the related descriptions, descriptions of well-known functions and configurations may be omitted for clarity and conciseness.

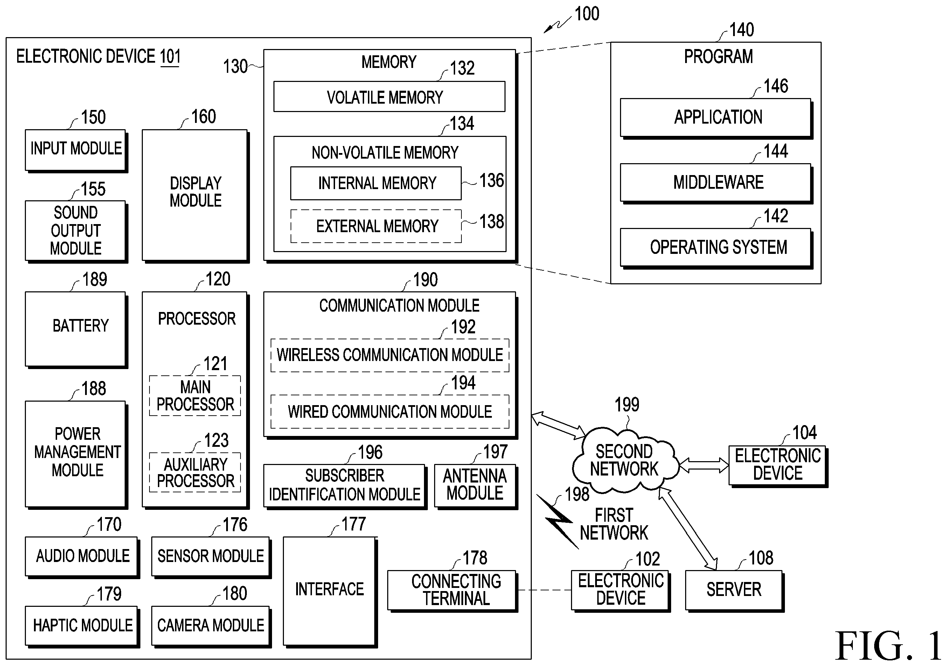

FIG. 1 is a block diagram illustrating an electronic device 101 in a network environment 100 according to various embodiments.

Referring to FIG. 1, in the network environment 100, the electronic device 101 may communicate with an electronic device 102 through a first network 198 (e.g., a short-range wireless communication network), or may communicate with at least one of an electronic device 104 or a server 108 through a second network 199 (e.g., a long-range wireless communication network). According to an embodiment, the electronic device 101 may communicate with the electronic device 104 through the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module 196, or an antenna module 197. In some embodiments, in the electronic device 101, at least one of these components (e.g., the connecting terminal 178) may be omitted, or one or more other components may be added. In some embodiments, some of these components (e.g., the sensor module 176, the camera module 180, or the antenna module 197) may be integrated into a single component (e.g., the display module 160).

The processor 120 may, for example, execute software (e.g., the program 140) to control at least one other component (e.g., a hardware or software component) of the electronic device 101 connected to the processor 120, and may perform various data processing or computations. According to an embodiment, as at least part of the data processing or computation, the processor 120 may store instructions or data received from another component (e.g., the sensor module 176 or the communication module 190) in volatile memory 132, process the instructions or data stored in the volatile memory 132, and store result data in non-volatile memory 134. According to an embodiment, the processor 120 may include a main processor 121 (e.g., a central processing unit or an application processor) or an auxiliary processor 123 (e.g., a graphics processing unit, a neural processing unit (NPU), an image signal processor, a sensor hub processor, or a communication processor) that is operable independently of, or together with, the main processor 121. For example, when the electronic device 101 includes the main processor 121 and the auxiliary processor 123, the auxiliary processor 123 may be configured to use less power than the main processor 121 or to be specialized for a specified function. The auxiliary processor 123 may be implemented separately from, or as a part of, the main processor 121.

The auxiliary processor 123 may, for example, control at least some of functions or states related to at least one component (e.g., the display module 160, the sensor module 176, or the communication module 190) among the components of the electronic device 101 in place of the main processor 121 while the main processor 121 is in an inactive (e.g., sleep) state, or together with the main processor 121 while the main processor 121 is in an active (e.g., application execution) state. According to an embodiment, the auxiliary processor 123 (e.g., the image signal processor or the communication processor) may be implemented as a part of another functionally related component (e.g., the camera module 180 or the communication module 190). According to an embodiment, the auxiliary processor 123 (e.g., the neural processing unit) may include a hardware structure specialized for processing an artificial intelligence model. The artificial intelligence model may be generated through machine learning. Such learning may, for example, be performed by the electronic device 101 itself in which the artificial intelligence model is performed, or may be performed through a separate server (e.g., the server 108). The learning algorithm may include, for example, supervised learning, unsupervised learning, semi-supervised learning, or reinforcement learning, but is not limited to the aforementioned examples. The artificial intelligence model may include a plurality of artificial neural network layers. The artificial neural network may be one of a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-networks, or a combination of two or more of the foregoing, but is not limited to the aforementioned examples. The artificial intelligence model may, additionally or alternatively, include a software structure in addition to the hardware structure.

The memory 130 may store various data used by at least one component (e.g., the processor 120 or the sensor module 176) of the electronic device 101. The data may include, for example, software (e.g., the program 140), and input data or output data for instructions related thereto. The memory 130 may include the volatile memory 132 or the non-volatile memory 134.

The program 140 may be stored as software in the memory 130, and may include, for example, an operating system 142, middleware 144, or an application 146.

The input module 150 may receive instructions or data to be used by a component (e.g., the processor 120) of the electronic device 101 from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as multimedia playback or recording playback. The receiver may be used to receive an incoming call. According to an embodiment, the receiver may be implemented separately from, or as a part of, the speaker.

The display module 160 may visually provide information to the outside (e.g., a user) of the electronic device 101. The display module 160 may include, for example, a display, a hologram device, or a projector, and a control circuit for controlling the corresponding device. According to an embodiment, the display module 160 may include a touch sensor configured to sense a touch, or a pressure sensor configured to measure the intensity of a force generated by the touch.

The audio module 170 may convert sound into an electrical signal, or vice versa, i.e., may convert an electrical signal into sound. According to an embodiment, the audio module 170 may acquire sound through the input module 150, or may output sound through the sound output module 155 or an external electronic device (e.g., the electronic device 102) (e.g., a speaker or headphones) connected directly or wirelessly to the electronic device 101.

The sensor module 176 may sense an operating state (e.g., power or temperature) of the electronic device 101 or an external environmental state (e.g., a user state), and may generate an electrical signal or data value corresponding to the sensed state. According to an embodiment, the sensor module 176 may include, for example, a gesture sensor, a gyro sensor, a barometric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols that may be used for the electronic device 101 to be connected directly or wirelessly to an external electronic device (e.g., the electronic device 102). According to an embodiment, the interface 177 may include, for example, a high definition multimedia interface (HDMI), a universal serial bus (USB) interface, an SD card interface, or an audio interface.

The connecting terminal 178 may include a connector through which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., vibration or movement) or an electrical stimulus that a user may perceive through a tactile or kinesthetic sense. According to an embodiment, the haptic module 179 may include, for example, a motor, a piezoelectric element, or an electrical stimulation device.

The camera module 180 may capture still images and videos. According to an embodiment, the camera module 180 may include one or more lenses, image sensors, image signal processors, or flashes.

The power management module 188 may manage power supplied to the electronic device 101. According to an embodiment, the power management module 188 may be implemented, for example, as at least a part of a power management integrated circuit (PMIC).

The battery 189 may supply power to at least one component of the electronic device 101. According to an embodiment, the battery 189 may include, for example, a non-rechargeable primary battery, a rechargeable secondary battery, or a fuel cell.

The communication module 190 may support establishment of a direct (e.g., wired) communication channel or a wireless communication channel between the electronic device 101 and an external electronic device (e.g., the electronic device 102, the electronic device 104, or the server 108), and performance of communication through the established communication channel. The communication module 190 may include one or more communication processors that operate independently of the processor 120 (e.g., an application processor) and support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication module). A corresponding communication module among these communication modules may communicate with an external electronic device 104 through a first network 198 (e.g., a short-range communication network such as Bluetooth, wireless fidelity (Wi-Fi) direct, or infrared data association (IrDA)) or a second network 199 (e.g., a long-range communication network such as a legacy cellular network, a 5G network, a next-generation communication network, the Internet, or a computer network (e.g., LAN or WAN)). These various types of communication modules may be integrated into one component (e.g., a single chip), or may be implemented as a plurality of components (e.g., multiple chips) separate from each other. The wireless communication module 192 may identify or authenticate the electronic device 101 within a communication network, such as the first network 198 or the second network 199, by using subscriber information (e.g., an international mobile subscriber identifier (IMSI)) stored in the subscriber identification module 196.

The wireless communication module 192 may support a 5G network beyond a 4G network, and a next-generation communication technology, for example, a new radio access technology (NR). The NR access technology may support high-speed transmission of high-capacity data (enhanced mobile broadband (eMBB)), terminal power minimization and access of a plurality of terminals (massive machine-type communications (mMTC)), or high reliability and low latency (ultra-reliable and low-latency communications (URLLC)). The wireless communication module 192 may, for example, support a high-frequency band (e.g., an mmWave band) to achieve a high data transmission rate. The wireless communication module 192 may support various technologies for securing performance in the high-frequency band, for example, beamforming, massive multiple-input and multiple-output (MIMO), full-dimensional MIMO (FD-MIMO), an array antenna, analog beamforming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for realizing eMBB, a loss coverage (e.g., 164 dB or less) for realizing mMTC, or a U-plane latency (e.g., 0.5 ms or less for each of downlink (DL) and uplink (UL), or a round trip of 1 ms or less) for realizing URLLC.

The antenna module 197 may transmit a signal or power to the outside (e.g., an external electronic device) or receive it from the outside. According to an embodiment, the antenna module 197 may include an antenna including a radiator made of a conductor or a conductive pattern formed on a substrate (e.g., a PCB). According to an embodiment, the antenna module 197 may include a plurality of antennas (e.g., an array antenna). In such a case, at least one antenna suitable for a communication scheme used in a communication network, such as the first network 198 or the second network 199, may be selected from the plurality of antennas, for example, by the communication module 190. A signal or power may be transmitted or received between the communication module 190 and an external electronic device through the at least one selected antenna. According to some embodiments, in addition to the radiator, another component (e.g., a radio frequency integrated circuit (RFIC)) may additionally be formed as a part of the antenna module 197.

According to various embodiments, the antenna module 197 may form an mmWave antenna module. According to an embodiment, the mmWave antenna module may include a printed circuit board, an RFIC disposed on or adjacent to a first surface (e.g., a lower surface) of the printed circuit board and capable of supporting a specified high-frequency band (e.g., an mmWave band), and a plurality of antennas (e.g., an array antenna) disposed on or adjacent to a second surface (e.g., an upper surface or a lateral surface) of the printed circuit board and capable of transmitting or receiving signals of the specified high-frequency band.

At least some of the components may be connected to each other through a peripheral device communication scheme (e.g., a bus, general purpose input and output (GPIO), serial peripheral interface (SPI), or mobile industry processor interface (MIPI)) and may exchange signals (e.g., commands or data) with each other.

According to an embodiment, the commands or data may be transmitted or received between the electronic device 101 and the external electronic device 104 through the server 108 connected to the second network 199. Each of the external electronic devices 102 or 104 may be a device of the same type as, or a different type from, the electronic device 101. According to an embodiment, all or some of the operations executed in the electronic device 101 may be executed in one or more external electronic devices among the external electronic devices 102, 104, or 108. For example, when the electronic device 101 needs to perform a certain function or service automatically, or in response to a request from a user or another device, the electronic device 101 may, instead of, or in addition to, executing the function or service by itself, request one or more external electronic devices to perform at least a part of the function or service. The one or more external electronic devices that have received the request may execute at least a part of the requested function or service, or an additional function or service related to the request, and may transfer a result of the execution to the electronic device 101. The electronic device 101 may provide the result, as it is or after additional processing, as at least a part of a response to the request. For this purpose, for example, cloud computing, distributed computing, mobile edge computing (MEC), or client-server computing technology may be used. The electronic device 101 may, for example, provide ultra-low-latency services using distributed computing or mobile edge computing. In another embodiment, the external electronic device 104 may include an Internet of things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology and IoT-related technology.

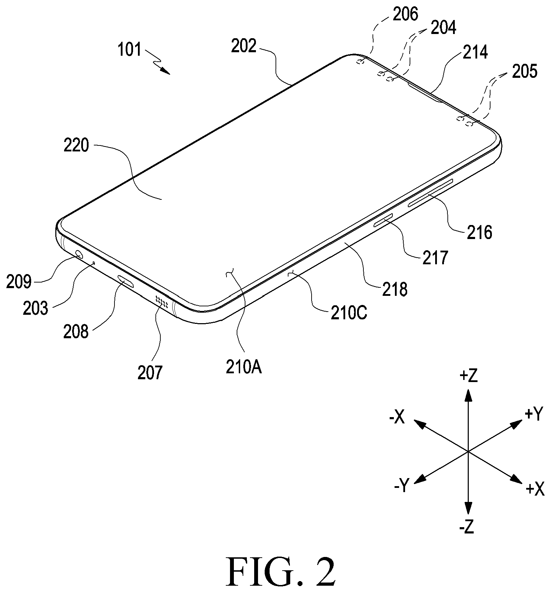

FIG. 2 is a perspective view illustrating a front surface of an electronic device according to an embodiment of the disclosure.

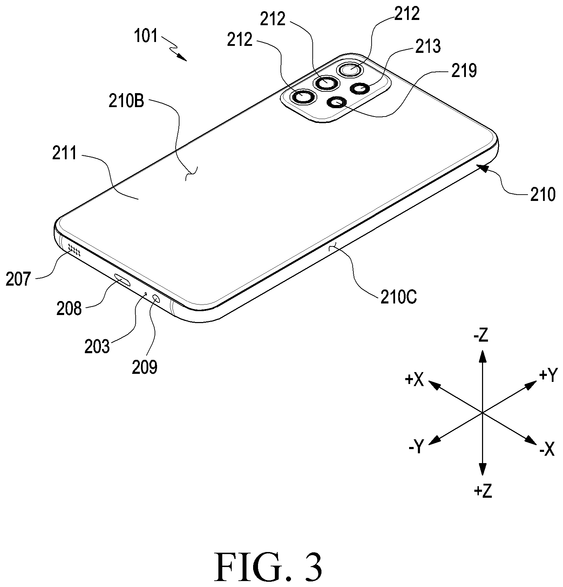

FIG. 3 is a perspective view illustrating a rear surface of an electronic device according to an embodiment of the disclosure.

Hereinafter, for convenience of description of FIGS. 2 to 12, FIGS. 2 to 12 illustrate an orthogonal coordinate system defined and interpreted by an X-axis, a Y-axis, and a Z-axis that are orthogonal to each other. Hereinafter, for convenience of description, the X-axis direction may be defined and interpreted as a width direction of the electronic device or components of the electronic device, the Y-axis direction may be defined and interpreted as a length direction of the electronic device or components of the electronic device, and the Z-axis direction may be defined and interpreted as a height direction (or thickness direction) of the electronic device or components of the electronic device. The electronic device or the components of the electronic device of the disclosure are not limited by the above directions.

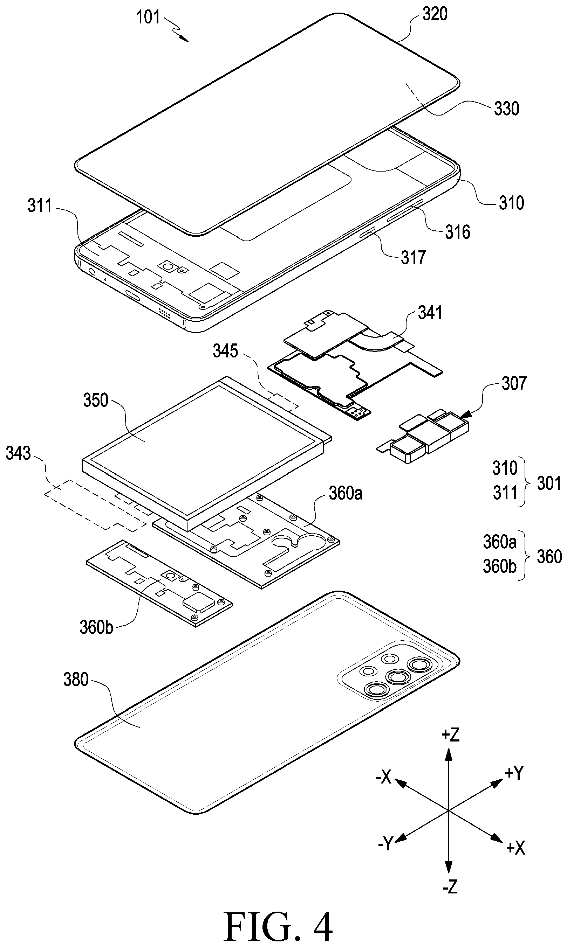

The embodiments of FIGS. 2 to 3 may be combinable with the embodiment of FIG. 1 or the embodiments of FIGS. 4 to 14.

Referring to FIGS. 2 to 3, an electronic device 101 (e.g., the electronic device 101 of FIG. 1) according to an embodiment may include a housing 210 including a first surface (or front surface) 210A, a second surface (or rear surface) 210B, and a lateral surface 210C surrounding a space between the first surface 210A and the second surface 210B. In an embodiment, the housing 210 may also refer to a structure forming a part of the first surface 210A of FIG. 2, the second surface 210B of FIG. 3, and the lateral surface 210C. According to an embodiment, the first surface 210A may be formed by a front plate 202 (e.g., a glass plate including various coating layers, or a polymer plate) at least a portion of which is substantially transparent. The second surface 210B may be formed by a rear plate 211 that is substantially opaque. The rear plate 211 may be formed, e.g., by coated or colored glass, ceramic, polymer, metal (e.g., aluminum, stainless steel (STS), or magnesium), or a combination of at least two of the above materials. The lateral surface 210C may be formed by a side structure (or "side bezel structure") 218 that is coupled to the front plate 202 and the rear plate 211 and includes metal and/or polymer. In an embodiment, the rear plate 211 and the side structure 218 may be integrally formed and may include the same material (e.g., a metal material such as aluminum).

Although not illustrated, the front plate 202 may include region(s) seamlessly extending while being bent toward the rear plate 211 from at least a part of an edge. In an embodiment, only one of the regions in which the front plate 202 (or the rear plate 211) is bent and extended toward the rear plate 211 (or the front plate 202) may be included at one edge of the first surface 210A. According to an embodiment, the front plate 202 or the rear plate 211 may have a substantially flat plate shape. For example, it may not include a region that is bent and extended. When the region that is bent and extended is included, the thickness of the electronic device 101 at the portion including the bent and extended region may be smaller than the thickness of the other portion.

According to an embodiment, the electronic device 101 may include at least one of a display 220, audio modules 203, 207, and 214, sensor modules 204 and 219, camera modules 205, 212, and 213, key input devices 216 and 217, a light emitting element 206, and connector holes 208 and 209. In an embodiment, the electronic device 101 may omit at least one (e.g., the key input devices 216 and 217 or the light emitting element 206) of the components or may additionally include another component.

The display 220 may be visually exposed, e.g., through a considerable portion of the front plate 202. In an embodiment, at least a portion of the display 220 may be visually exposed through the front plate 202 forming the first surface 210A or through a portion of the lateral surface 210C. In an embodiment, an edge of the display 220 may be formed substantially identically to an adjacent outer shape of the front plate 202. In an embodiment (not illustrated), in order to expand an area in which the display 220 is visually exposed, the distance between the outer edge of the display 220 and the outer edge of the front plate 202 may be formed to be substantially the same.

In an embodiment, a recess or an opening may be formed in a part of a screen display area of the display 220, and at least one of the audio module 214, the sensor module 204, the camera module 205, and the light emitting element 206 aligned with the recess or the opening may be included. In an embodiment, at least one of the audio module 214, the sensor module 204, the camera module 205, a fingerprint sensor, and the light emitting element 206 may be included on a rear surface of the screen display area of the display 220. In an embodiment, the display 220 may be coupled to or disposed adjacent to a touch sensing circuit, a pressure sensor capable of measuring the intensity (pressure) of a touch, and/or a digitizer detecting a magnetic field-type stylus pen.

The audio modules 203, 207, and 214 may include a microphone hole 203 and speaker holes 207 and 214. A microphone for acquiring external sound may be disposed inside the microphone hole 203, and in an embodiment, a plurality of microphones may be disposed to detect the direction of sound. The speaker holes 207 and 214 may include an external speaker hole 207 and a receiver hole 214 for a call. In an embodiment, the speaker holes 207 and 214 and the microphone hole 203 may be implemented as a single hole, or a speaker may be included without the speaker holes 207 and 214 (e.g., a piezo speaker).

The sensor modules 204 and 219 may generate electrical signals or data values corresponding to an internal operating state of the electronic device 101 or an external environmental state. The sensor modules 204 and 219 may include, e.g., a first sensor module 204 (e.g., a proximity sensor) and/or a second sensor module (e.g., a fingerprint sensor) disposed on the first surface 210A of the housing 210, and/or a third sensor module 219 and/or a fourth sensor module (e.g., a fingerprint sensor) disposed on the second surface 210B of the housing 210. The fingerprint sensor may be disposed on the second surface 210B or the lateral surface 210C as well as on the first surface 210A (e.g., the display 220) of the housing 210. The electronic device 101 may further include at least one of, e.g., a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, and 213 may include a first camera device 205 disposed on the first surface 210A of the electronic device 101, a second camera device 212 disposed on the second surface 210B, and/or a flash 213. The camera devices 205 and 212 may include one or a plurality of lenses, an image sensor, and/or an image signal processor. The flash 213 may include, e.g., a light emitting diode or a xenon lamp. In an embodiment, two or more lenses (an infrared camera, a wide-angle lens, and a telephoto lens) and image sensors may be disposed on one surface of the electronic device 101. In an embodiment, the flash 213 may emit infrared rays, and the infrared rays emitted by the flash 213 and reflected by a subject may be received through the third sensor module 219. The electronic device 101 or a processor of the electronic device 101 may detect depth information of the subject based on the time when the infrared rays are received at the third sensor module 219.

The key input devices 216 and 217 may be disposed on one surface of the housing 210. For example, the key input devices 216 and 217 may be disposed on the lateral surface 210C of the housing 210. In an embodiment, the electronic device 101 may not include some or all of the above-mentioned key input devices 216 and 217, and the key input device not included may be implemented in another form, such as a soft key, on the display 220. In an embodiment, the key input devices 216 and 217 may include a sensor module disposed on the second surface 210B of the housing 210.

According to an embodiment, the key input devices 216 and 217 may be defined and/or referred to as a side key, a key input module, or a button assembly.

According to an embodiment, the key input devices 216 and 217 may include a volume key 216 or a power key 217. The volume key 216 may be a key capable of adjusting the intensity of an acoustic signal output from the electronic device 101. The volume key 216 may have an elongated shape when viewed from a side of the electronic device 101 (e.g., when viewed from the +X direction toward the -X direction in FIGS. 2 and 3). As the volume key 216 is provided in the elongated shape, a key input for volume up may be possible at one side of the volume key 216, and a key input for volume down may be possible at the other side of the volume key 216. For example, when viewed from a side of the electronic device 101, the volume key 216 may visually appear as a single member, but the volume key 216 may provide two key input points. The volume key 216 is configured to adjust the intensity of an acoustic signal, but is not limited thereto, and may provide a scroll up-down adjustment, a text size adjustment, or other key input functions.

According to an embodiment, the power key 217 may be spaced apart from the volume key 216. The power key 217 may be configured to control on-off of the electronic device 101 or to control a standby mode and an activation mode of the electronic device 101.

The light emitting element 206 may be disposed, e.g., on the first surface 210A of the housing 210. The light emitting element 206 may provide, e.g., status information of the electronic device 101 in the form of light. In an embodiment, the light emitting element 206 may provide, e.g., a light source linked to the operation of the camera module 205. The light emitting element 206 may include, e.g., a light emitting diode (LED), an infrared (IR) LED, and a xenon lamp.

The connector holes 208 and 209 may include a first connector hole 208 capable of accommodating a connector (e.g., a USB connector) for transmitting/receiving power and/or data to/from an external electronic device, and/or a second connector hole (e.g., an earphone jack) 209 capable of accommodating a connector for transmitting/receiving an audio signal to/from an external electronic device.

FIG. 4 is an exploded perspective view illustrating a front surface of an electronic device according to an embodiment of the disclosure.

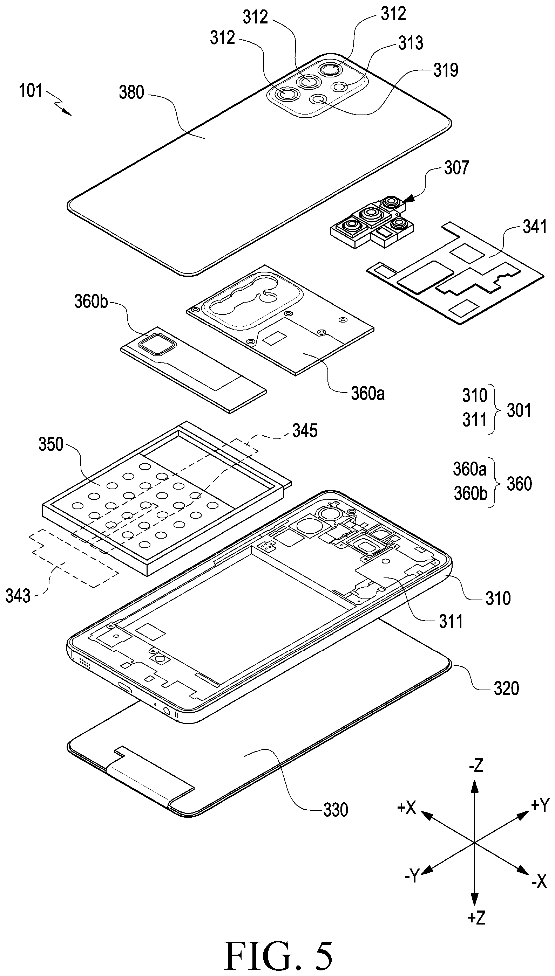

FIG. 5 is an exploded perspective view illustrating a rear surface of an electronic device according to an embodiment of the disclosure.

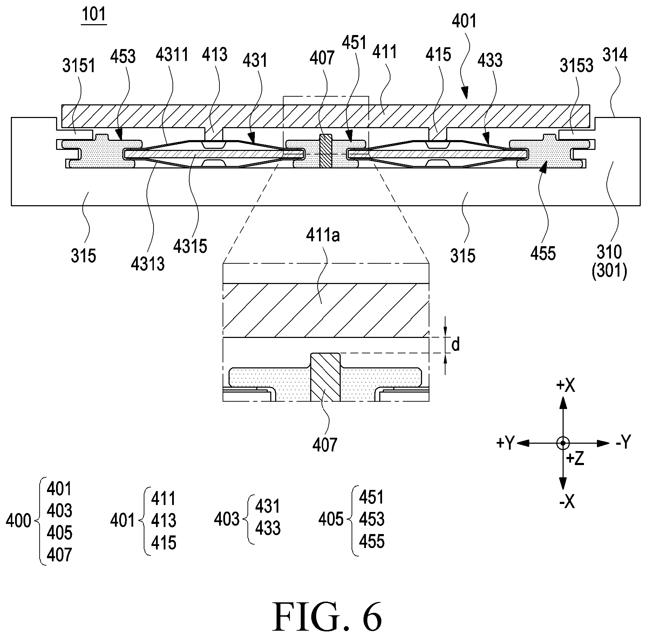

The embodiments of FIGS. 4 to 5 may be combinable with the embodiments of FIGS. 1 to 3 or the embodiments of FIGS. 6 to 14.

Referring to FIGS. 4 and 5, an electronic device 101 (e.g., the electronic device 101 of FIG. 1 or the electronic device 101 of FIGS. 2 to 3) may include a side structure 310, a first support member 311 (e.g., a bracket), a front plate 320 (e.g., the front plate 202 of FIG. 2), a display 330 (e.g., the display 220 of FIG. 2), at least one printed circuit board (or board assembly) 341 and 343, a battery 350, a second support member 360 (e.g., a rear case), an antenna, a camera assembly 307, and a rear plate 380 (e.g., the rear plate 211 of FIG. 2). When the electronic device 101 includes a plurality of printed circuit boards 341 and 343, the electronic device 101 may include at least one flexible connection member 345 to electrically connect different printed circuit boards to each other. For example, the printed circuit boards 341 and 343 may include a first circuit board 341 disposed above the battery 350 (e.g., in the +Y-axis direction) and a second circuit board 343 disposed below the battery 350 (e.g., in the -Y-axis direction), and the flexible connection member 345 may electrically connect the first circuit board 341 and the second circuit board 343.

According to an embodiment, the electronic device 101 may omit at least one (e.g., the first support member 311 or the second support member 360) of the components or may additionally include another component. At least one of the components of the electronic device 101 may be the same as or similar to at least one of the components of the electronic device 101 of FIGS. 1 to 3, and a redundant description will be omitted below.

According to an embodiment, at least a portion of the first support member 311 may be provided in a flat plate shape. In an embodiment, the first support member 311 may be disposed inside the electronic device 101 and connected to the side structure 310, or may be integrally formed with the side structure 310. The first support member 311 may be formed of, e.g., a metal material and/or a non-metal (e.g., polymer) material. When the first support member 311 is at least partially formed of a metal material, the side structure 310 or a part of the first support member 311 may function as an antenna. The display 330 may be coupled to one surface of the first support member 311, and the printed circuit boards 341 and 343 may be coupled to the other surface thereof. A processor, memory, and/or an interface may be mounted on the printed circuit boards 341 and 343. The processor may include, e.g., one or more of a central processing unit, an application processor, a graphic processing unit, an image signal processor, a sensor hub processor, or a communication processor.

According to an embodiment, the first support member 311 and the side structure 310 may be combined and referred to as a front case or housing 301. According to an embodiment, the housing 301 may be understood as a structure for generally accommodating, protecting, or arranging the printed circuit boards 341 and 343 or the battery 350. In an embodiment, the housing 301 may be understood as including a structure that a user may visually or tactilely perceive from the exterior of the electronic device 101, e.g., the side structure 310, the front plate 320, and/or the rear plate 380. In an embodiment, "the front surface or rear surface of the housing 301" may refer to the first surface 210A of FIG. 2 or the second surface 210B of FIG. 3. In an embodiment, the first support member 311 is disposed between the front plate 320 (e.g., the first surface 210A of FIG. 2) and the rear plate 380 (e.g., the second surface 210B of FIG. 3), and may function as a structure for arranging electrical/electronic components such as the printed circuit boards 341 and 343 or the camera assembly 307.

According to an embodiment, the memory may include, e.g., a volatile memory (e.g., the volatile memory 132 of FIG. 1) or a non-volatile memory (e.g., the non-volatile memory 134 of FIG. 1).

According to an embodiment, the interface may include, e.g., a high definition multimedia interface (HDMI), a universal serial bus (USB) interface, a secure digital (SD) card interface, and/or an audio interface. The interface may, e.g., electrically or physically connect the electronic device 101 to an external electronic device, and may include a USB connector, an SD card/multimedia card (MMC) connector, or an audio connector.

According to an embodiment, the second support member 360 may include, e.g., an upper support member 360a and a lower support member 360b. In an embodiment, the upper support member 360a may be arranged to surround the printed circuit boards 341 and 343 (e.g., the first circuit board 341) together with a part of the first support member 311. For example, the upper support member 360a of the second support member 360 may be disposed to face the first support member 311 with the first circuit board 341 interposed therebetween. In an embodiment, the lower support member 360b of the second support member 360 may be disposed to face the first support member 311 with the second circuit board 343 interposed therebetween. A circuit device (e.g., a processor, a communication module, or memory) implemented in the form of an integrated circuit chip or various electrical/electronic components may be disposed on the printed circuit boards 341 and 343, and according to an embodiment, the printed circuit boards 341 and 343 may be provided with an electromagnetic shielding environment from the second support member 360. In an embodiment, the lower support member 360b may be utilized as a structure on which electrical/electronic components such as a speaker module or an interface (e.g., a USB connector, an SD card/MMC connector, or an audio connector) may be disposed. In an embodiment, an electrical/electronic component such as a speaker module or an interface (e.g., a USB connector, an SD card/MMC connector, or an audio connector) may be disposed on an additional printed circuit board (not illustrated). For example, the lower support member 360b may be arranged to surround the additional printed circuit board together with another part of the first support member 311. The speaker module or the interface disposed on the additional printed circuit board (not illustrated) or the lower support member 360b may be disposed to correspond to the audio module 207 or the connector holes 208 and 209 of FIG. 2.

According to an embodiment, the battery 350 is a device for supplying power to at least one component of the electronic device 101, and may include, e.g., a non-rechargeable primary battery, a rechargeable secondary battery, or a fuel cell. At least a part of the battery 350 may be disposed, e.g., substantially on the same plane as the printed circuit boards 341 and 343. The battery 350 may be integrally disposed inside the electronic device 101, or may be detachably disposed with respect to the electronic device 101.

Although not illustrated, the antenna may include, e.g., a conductor pattern implemented on a surface of the second support member 360 through a laser direct structuring process. In an embodiment, the antenna may include a printed circuit pattern formed on a surface of a thin film, and the antenna in the form of a thin film may be disposed between the rear plate 380 and the battery 350. The antenna may include, e.g., a near field communication (NFC) antenna, a wireless charging antenna, and/or a magnetic secure transmission (MST) antenna. The antenna may, e.g., perform near-field communication with an external device or wirelessly transmit/receive power required for charging. In an embodiment, another antenna structure may be formed by a part of the side structure 310 and/or the first support member 311, or a combination thereof.

According to an embodiment, the camera assembly 307 may include at least one camera module. Inside the electronic device 101, the camera assembly 307 (or the at least one camera module) may receive at least a part of light incident through an optical hole or camera windows 312, 313, and 319. In an embodiment, the camera assembly 307 may be disposed on the first support member 311 at a position adjacent to the printed circuit boards 341 and 343. In an embodiment, the camera module(s) of the camera assembly 307 may be generally aligned with any one of the camera windows 312, 313, and 319, and may be at least partially surrounded by the second support member 360 (e.g., the upper support member 360a).

According to an embodiment, the electronic device 101 may include a flexible connection member 345. The flexible connection member 345 may include a flexible flat cable (FFC), a flexible printed circuit board (FPCB), or a board to board (B2B) connector.

According to an embodiment, the flexible connection member 345 may be at least partially bendable. For example, the flexible connection member 345 may be configured to be at least partially folded or unfolded.

According to an embodiment, the flexible connection member 345 may electrically connect the first circuit board 341 (e.g., a main circuit board) and at least one electrical component. For example, one end of the flexible connection member 345 may be physically and/or electrically connected to at least a part of the first circuit board 341. For example, the other end of the flexible connection member 345 may be physically and/or electrically connected to at least a part of the at least one electrical component. The at least one electrical component may include, e.g., the second circuit board 343 (e.g., a sub circuit board). However, the at least one electrical component is not limited thereto, and may include various electrical components (e.g., an antenna, a speaker, a battery, a display, or a sensor).

According to an embodiment, the flexible connection member 345 may be configured to transfer power or an electrical signal from the first circuit board 341 to the at least one electrical component. The flexible connection member 345 may be configured to transfer power or an electrical signal from the at least one electrical component to the first circuit board 341. The electrical signal may include a control signal, a power signal, or a communication signal.

According to an embodiment, the electronic device 101 may include key input devices 316 and 317 (e.g., the key input devices 216 and 217 of FIG. 2). The key input devices 316 and 317 may include a volume key 316 (e.g., the volume key 216 of FIG. 2) or a power key (e.g., the power key 217 of FIG. 2).

According to an embodiment, the volume key 316 may be disposed on one surface of the housing 301. For example, the volume key 316 may be disposed on a part of a lateral surface (e.g., the side structure 310 of FIG. 4) of the housing 301, but is not limited thereto.

According to an embodiment, the volume key 316 may include a haptic module (e.g., the haptic module 179 of FIG. 1). The haptic module may include a piezo actuator. The piezo actuator may be configured to provide, when a user presses or touches the volume key 316, mechanical stimulation (e.g., vibration or movement) that the user may perceive through a tactile or kinesthetic sensation.

According to an embodiment, the volume key 316 may have an elongated shape when viewed from a side of the electronic device 101 (e.g., when viewed from the +X direction toward the -X direction in FIG. 4). The volume key 316 may be spaced apart from the power key 317.

FIG. 6 is a cross-sectional view illustrating an electronic device including a piezo actuator according to an embodiment of the disclosure.

FIG. 6 is a cross-sectional view illustrating a housing and a key input device assembled to a part of the housing according to an embodiment of the disclosure.

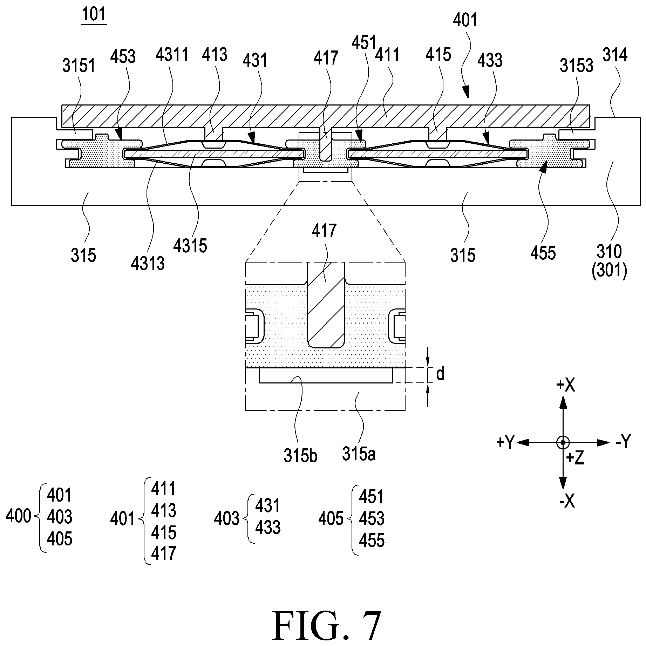

The embodiment of FIG. 6 may be combined with the embodiments of FIGS. 1 to 5 or the embodiments of FIGS. 7 to 14.

Referring to FIG. 6, an electronic device 101 (e.g., the electronic device 101 of FIG. 1 or the electronic device 101 of FIGS. 2 to 5) may include a housing 301 (e.g., the housing 301 of FIGS. 4 to 5) or a key input device 400 (e.g., the volume key 316 of FIG. 4).

According to an embodiment, the housing 301 may include a side structure 310 (e.g., the side structure 310 of FIGS. 4 to 5). The side structure 310 may form at least a part of a lateral surface 314 of the electronic device 101. The lateral surface 314 may be defined and/or referred to as one surface of the electronic device 101 and/or the housing 301.

According to an embodiment, the key input device 400 may include a button 401, a plurality of piezo actuators 403, a plurality of holders 405, or a support portion 407.

According to an embodiment, the button 401 may be exposed to the outside of the electronic device 101. The button 401 may be disposed on one surface of the housing 301. The button 401 may be disposed on at least a part (e.g., the lateral surface 314) of the side structure 310. The electronic device 101 may be configured to identify a user input by detecting a pressure change or an electrical change generated based on the user pressing or touching the button 401. The button 401 may include stainless steel, but is not limited thereto.

According to an embodiment, the button 401 may be movably coupled to one surface of the housing 301. For example, when the button 401 is pressed or touched by a user, the button 401 may move in a first direction (e.g., the -X direction in FIG. 6). When the press or touch by the user on the button 401 is released, the button 401 may move in a second direction (e.g., the +X direction in FIG. 6) opposite to the first direction.

According to an embodiment, the key input device 400 may be at least partially accommodated in a groove or a recess formed in one surface of the housing 301. For example, the key input device 400 may be assembled to the groove or the recess formed in one surface of the housing 301.

According to an embodiment, the button 401 may be spaced apart from the housing 301. For example, the button 401 may be a member separate from the housing 301.

Although not illustrated, the button 401 may be integrally formed with the housing 301. For example, at least a portion of the housing 301 may be configured to be at least partially deformable with respect to another portion of the housing 301 when touched or pressed by a user. The at least a portion of the deformable housing 301 may be defined and/or interpreted as the button 401.

According to an embodiment, the button 401 may include a base 411 exposed to the outside of the housing 301. The base 411 may be arranged to be pressed or touched by a user. The base 411 may be visually exposed to the outside of the electronic device 101. The base 411 may have an elongated shape when viewed from the outside of the electronic device 101 (e.g., when viewed from +X toward -X in FIG. 6).

According to an embodiment, the button 401 may include a first protruding portion 413. The first protruding portion 413 may protrude from the base 411 to a first piezo actuator 431. According to an embodiment, the first protruding portion 413 may be defined as extending from the base 411 toward the first piezo actuator 431.

According to an embodiment, the first protruding portion 413 may be in contact with the first piezo actuator 431. The first protruding portion 413 may be supported by the first piezo actuator 431. The first piezo actuator 431 may press the first protruding portion 413 with a force that causes the button 401 moved in the first direction (e.g., the -X direction in FIG. 6) to move in the second direction (e.g., the +X direction in FIG. 6).

According to an embodiment, the button 401 may include a second protruding portion 415. The second protruding portion 415 may protrude from the base 411 to a second piezo actuator 433. According to an embodiment, the second protruding portion 415 may be defined as extending from the base 411 toward the first piezo actuator 431.

According to an embodiment, the second protruding portion 415 may be in contact with the second piezo actuator 433. The second protruding portion 415 may be supported by the second piezo actuator 433. The second piezo actuator 433 may press the second protruding portion 415 with a force that causes the button 401 moved in the first direction (e.g., the -X direction in FIG. 6) to move in the second direction (e.g., the +X direction in FIG. 6).

According to an embodiment, the plurality of piezo actuators 403 may be disposed inside the button 401. Being disposed inside the button 401 may be defined as being covered by the button 401 and not exposed to the outside of the electronic device 101.

According to an embodiment, the number of the plurality of piezo actuators 403 may be greater than the number of the buttons 401. For example, when the number of the buttons 401 of one key input device 400 is one, the number of the plurality of piezo actuators 403 of the key input device 400 may be two or more.

According to an embodiment, the plurality of piezo actuators 403 may include the first piezo actuator 431 or the second piezo actuator 433.

According to an embodiment, the first piezo actuator 431 and the second piezo actuator 433 may be spaced apart from each other. The first piezo actuator 431 and the second piezo actuator 433 may be arranged in parallel along the elongated direction (e.g., the Y-axis direction in FIG. 6) or the length direction (e.g., the Y-axis direction in FIG. 6) of the button 401 having the elongated shape.

According to an embodiment, the first piezo actuator 431 may be disposed between a first holder 451 and a second holder 453. The first piezo actuator 431 may be coupled to the first holder 451 and the second holder 453.

According to an embodiment, the first piezo actuator 431 may include a piezo material 4315, a first disk 4311 disposed on one surface of the piezo material 4315, and a second disk 4313 disposed on the other surface of the piezo material 4315. The disks 4311 and 4313 may be referred to as cymbals.

According to an embodiment, the piezo material 4315 may be mechanically deformed by an electric field formed by applying a voltage to an electrode (not illustrated) of the first piezo actuator 431. For example, the piezo material 4315 may contract or expand due to the electric field. The first disk 4311 and the second disk 4313 may be configured to vibrate by the mechanical deformation of the piezo material 4315. Accordingly, as the button 401 connected to the first disk 4311 vibrates together, the user may be provided with haptic feedback.

According to an embodiment, the piezo material 4315 may include a ceramic capable of providing a piezo effect, but is not limited thereto. The piezo material 4315 may have a plate shape, but is not limited thereto.

According to an embodiment, the first disk 4311 may have a leaf spring shape. The first disk 4311 may be coupled to the piezo material 4315. The first disk 4311 may be configured to press the first protruding portion 413. When the first disk 4311 vibrates, the vibration may be transmitted to the base 411 through the first protruding portion 413.

According to an embodiment, as the first disk 4311 presses the first protruding portion 413, the button 401 and/or the base 411 may be restricted and/or reduced from sagging in the first direction (e.g., the -X direction in FIG. 6).

According to an embodiment, the second disk 4313 may have a leaf spring shape. The second disk 4313 may be coupled to the piezo material 4315. The second disk 4313 may be supported by an inner portion 315 of the side structure 310. The inner portion 315 may be a portion of the side structure 310 that is not exposed to the outside of the electronic device 101.

Although not illustrated, the second disk 4313 may also be supported by a separate support member (e.g., stainless steel (STS)) disposed on the inner portion 315.

Although not illustrated, when the key input device 400 is a module-type component including a case surrounding the piezo actuators 403 and the holders 405, the second disk 4313 may also be supported by the case.

According to an embodiment, the disks 4311 and 4313 may include stainless steel, but are not limited thereto.

According to an embodiment, one side of the first piezo actuator 431 may be coupled to the first holder 451. The other side of the first piezo actuator 431 may be coupled to the second holder 453.

According to an embodiment, the second piezo actuator 433 may include a piezo material, a first disk, and a second disk. The configurations of the piezo material, the first disk, and the second disk of the second piezo actuator 433 may be substantially the same as the configurations of the piezo material, the first disk, and the second disk of the first piezo actuator 431. The description of the piezo material, the first disk, and the second disk of the second piezo actuator 433 may refer to the description of the piezo material, the first disk, and the second disk of the first piezo actuator 431.

According to an embodiment, one side of the second piezo actuator 433 may be coupled to the first holder 451. The other side of the second piezo actuator 433 may be coupled to a third holder 455.

According to an embodiment, the plurality of holders 405 may include the first holder 451, the second holder 453, or the third holder 455. For example, the number of the plurality of holders 405 may be greater than the number of the plurality of piezo actuators 403.

According to an embodiment, the plurality of holders 405 may include an elastically deformable material. For example, the plurality of holders 405 may include rubber.

According to an embodiment, the first holder 451 may be disposed between the first piezo actuator 431 and the second piezo actuator 433. The first piezo actuator 431 and the second piezo actuator 433 may be coupled to the first holder 451. The first holder 451 may include a groove or a recess configured such that at least a portion of the piezo actuators 431 and 433 is inserted thereinto.

According to an embodiment, the first holder 451 may be supported by the inner portion 315 of the side structure 310. The first holder 451 may be configured to fix the positions of the piezo actuators 431 and 433.

According to an embodiment, the first piezo actuator 431 may be coupled to the second holder 453. The second holder 453 may include a groove or a recess configured such that at least a part of the first piezo actuator 431 and at least a part of the side structure 310 are inserted thereinto.

According to an embodiment, the second holder 453 may be supported by the inner portion 315 of the side structure 310. The second holder 453 may be configured to fix the position of the first piezo actuator 431.

According to an embodiment, the second piezo actuator 433 may be coupled to the third holder 455. The third holder 455 may include a groove or a recess configured such that at least a part of the second piezo actuator 433 and at least a part of the side structure 310 are inserted thereinto.

According to an embodiment, the third holder 455 may be supported by the inner portion 315 of the side structure 310. The third holder 455 may be configured to fix the position of the second piezo actuator 433.

According to an embodiment, the housing 301 may include a first stopper 3151 or a second stopper 3153.

According to an embodiment, the first stopper 3151 may be positioned between the base 411 and the second holder 453. The first stopper 3151 may protrude from at least a portion of the inner portion 315. The first stopper 3151 may restrict and/or reduce excessive sagging of the base 411 when a pressure generated by the user is applied to the base 411.

According to an embodiment, the second stopper 3153 may be positioned between the base 411 and the third holder 455. The second stopper 3153 may protrude from at least a portion of the inner portion 315. The second stopper 3153 may restrict and/or reduce excessive sagging of the base 411 when a pressure generated by the user is applied to the base 411.

According to an embodiment, the support portion 407 may be configured to support at least a portion of the button 401. For example, the support portion 407 may be configured to support a portion of the button 401 (e.g., a portion 411a of the base 411) corresponding to the support portion 407. The support portion 407 may be defined and/or referred to as a pole extending in one direction, but is not limited thereto.

According to an embodiment, the support portion 407 may be separated from the button 401. For example, the support portion 407 may be a member separate from the button 401.

According to an embodiment, the support portion 407 may be inserted into the first holder 451. At least a part of the support portion 407 may be exposed to the outside of the first holder 451. The support portion 407 may have a rigid material. For example, the support portion 407 may include stainless steel, but is not limited thereto. The support portion 407 may be injection-molded together with the first holder 451, but is not limited thereto. The support portion 407 may be spaced apart from the portion 411a of the base 411 corresponding to the support portion 407 by a specified gap or interval d in a state in which the user does not press the button 401. The interval d may be about 0.09 mm to about 0.10 mm, but is not limited thereto. The support portion 407 may be in contact with the portion 411a of the base 411 corresponding to the support portion 407 in a state in which the user presses the button 401 (e.g., a state in which the base 411 is moved or deformed). As the portion 411a of the base 411 is supported by the support portion 407, excessive deformation of the base 411 may be restricted and/or reduced. The piezo actuators 431 and 433 may be restricted and/or reduced from being excessively pressed or subjected to excessive stress by the first protruding portion 413 and/or the second protruding portion 415. Accordingly, damage to the piezo material of the piezo actuators 431 and 433 having a relatively weak material may be restricted and/or reduced.

According to an embodiment, an outer surface (e.g., a surface facing the +X direction in FIG. 6) of the button 401 and/or the base 411 may be disposed to be stepped with the lateral surface 314 of the housing 301, but is not limited thereto.

According to an embodiment, the key input device 400 may detect a user's key input through the plurality of piezo actuators 403. For example, when a user presses the button 401, deformation of the disks of the plurality of piezo actuators 403 may be caused by the button 401. As the disks of the plurality of piezo actuators 403 are deformed, the piezo material of the plurality of piezo actuators 403 may also be deformed. The electrodes of the plurality of piezo actuators 403 may detect an electric field or a change in the electric field generated as the piezo material is deformed. The electronic device 101 may be configured to detect the user input by the change in the electric field. When the user presses a portion of the base 411 corresponding to the first piezo actuator 431, the electronic device 101 may determine that a key (e.g., volume-up) has been input. When the user presses a portion of the base 411 corresponding to the second piezo actuator 433, the electronic device 101 may determine that a key (e.g., volume-down) has been input. According to an embodiment, when a key input in which the user touches the base 411 in a sliding manner, e.g., a key input sliding from a portion of the base corresponding to one piezo actuator to another portion of the base corresponding to the other piezo actuator, is input, the electronic device 101 may determine that a key (e.g., a swipe gesture) has been input. According to an embodiment, the electronic device 101 may provide haptic feedback to the user by operating a piezo actuator corresponding to a portion of the base 411 touched by the user.

According to an embodiment, the key input device 400 may be electrically connected to a circuit board of the electronic device 101 (e.g., the first circuit board 341 or the second circuit board 343 of FIGS. 4 to 5) through a conductive connection member (e.g., FPCB). For example, the key input device 400 may be electrically connected to a processor (e.g., the processor 120 of FIG. 1) disposed on the conductive connection member and the circuit board. The conductive connection member may be configured to transmit a user's key input signal or transmit a haptic feedback control signal.

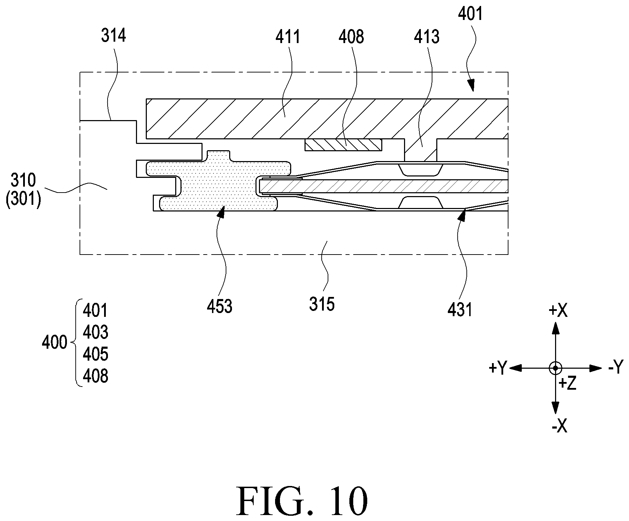

According to an embodiment, the key input device 400 may detect a user's key input through a sensor separate from the plurality of piezo actuators 403. When a user's key input is detected through the separate sensor, the electronic device 101 may provide haptic feedback to the user by operating a piezo actuator corresponding to a portion of the base 411 touched by the user. The configuration for detecting the user's key input through the separate sensor will be described in more detail below with reference to FIGS. 10 to 12.

FIG. 7 is a cross-sectional view illustrating an electronic device including a piezo actuator according to an embodiment of the disclosure.

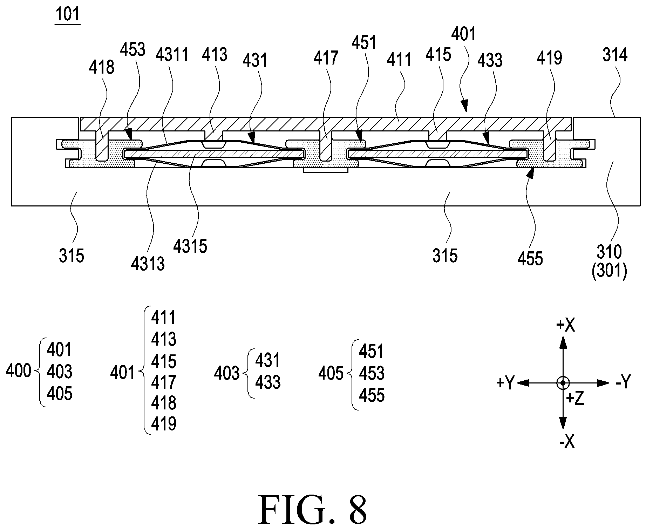

The embodiment of FIG. 7 may be combined with the embodiments of FIGS. 1 to 6 or the embodiments of FIGS. 8 to 14.

Referring to FIG. 7, an electronic device 101 (e.g., the electronic device 101 of FIG. 1 or the electronic device 101 of FIGS. 2 to 5) may include a housing 301 (e.g., the housing 301 of FIGS. 4 to 5) or a key input device 400 (e.g., the volume key 316 of FIG. 4).

At least one of the components of the electronic device 101, the housing 301, and/or the key input device 400 of FIG. 7 may be the same as or similar to at least one of the components of the electronic device 101, the housing 301, and/or the key input device 400 described with reference to FIG. 6 as an example, and a redundant description will be omitted below.

According to an embodiment, the button 401 may include a support portion 417 (e.g., the support portion 407 of FIG. 6). The support portion 417 may be configured to support at least a portion of the button 401. For example, the support portion 417 may be configured to support a portion of the base 411 connected to the support portion 407. The support portion 417 may be defined and/or referred to as a pole extending in one direction, but is not limited thereto.

According to an embodiment, the support portion 417 may be integrally formed with the base 411. The support portion 417 may be manufactured as a member separate from the base 411 and may be coupled to the base 411.

According to an embodiment, the support portion 417 may extend from the base 411 toward the first holder 451. For example, the support portion 417 may extend or protrude from a portion of the base 411 corresponding to the first holder 451. At least a portion of the support portion 417 may be inserted into the first holder 451. The support portion 417 may have a rigid material. For example, the support portion 417 may include stainless steel, but is not limited thereto.

According to an embodiment, the inner portion 315 configured to support one surface (e.g., a surface facing the -X direction in FIG. 7) of the first holder 451 may include an accommodating portion 315b that is at least partially recessed. The accommodating portion 315b may be formed at a position corresponding to the support portion 417 in the inner portion 315.

According to an embodiment, in a state in which the user does not press the button 401, the one surface of the first holder 451 may be spaced apart from a portion 315a of the inner portion 315 in which the accommodating portion 315b is formed by a specified gap or interval d. The interval d may be about 0.09 mm to about 0.10 mm, but is not limited thereto. The support portion 417 may move in the first direction (e.g., the -X direction in FIG. 7) in a state in which the user presses the button 401 (e.g., a state in which the base 411 is moved or deformed). In this case, at least a portion of the first holder 451 to which the support portion 417 is fixed may be deformed. A part of the deformed first holder 451 may be accommodated in the accommodating portion 315b, and may be supported by a bottom surface (e.g., a surface facing the -X direction in FIG. 7) defining the accommodating portion 315a. As the first holder 451 is supported, excessive deformation of the base 411 may be restricted and/or reduced. The piezo actuators 431 and 433 may be restricted and/or reduced from being excessively pressed or subjected to excessive stress by the first protruding portion 413 and/or the second protruding portion 415. Accordingly, damage to the piezo material of the piezo actuators 431 and 433 having a relatively weak material may be restricted and/or reduced.

FIG. 8 is a cross-sectional view illustrating an electronic device including a piezo actuator according to an embodiment of the disclosure.

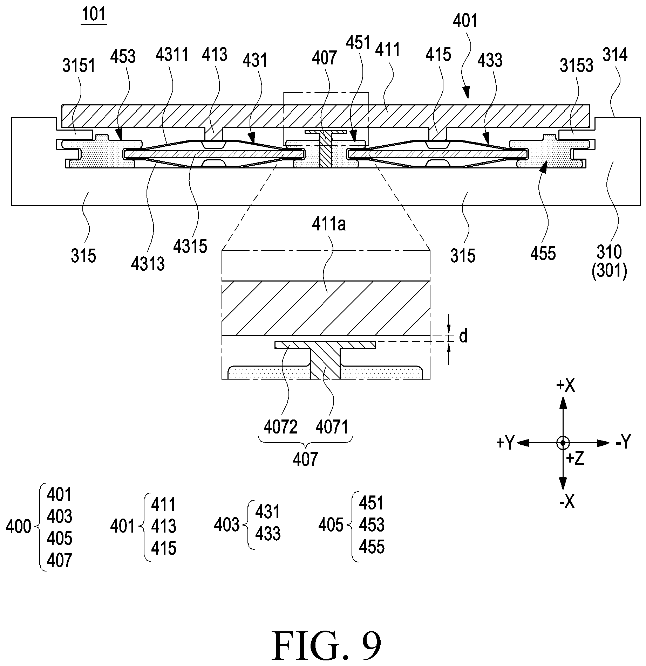

The embodiment of FIG. 8 may be combined with the embodiments of FIGS. 1 to 7 or the embodiments of FIGS. 9 to 14.

Referring to FIG. 8, an electronic device 101 (e.g., the electronic device 101 of FIG. 1 or the electronic device 101 of FIGS. 2 to 5) may include a housing 301 (e.g., the housing 301 of FIGS. 4 to 5) or a key input device 400 (e.g., the volume key 316 of FIG. 4).

At least one of the components of the electronic device 101, the housing 301, and/or the key input device 400 of FIG. 8 may be the same as or similar to at least one of the components of the electronic device 101, the housing 301, and/or the key input device 400 described with reference to FIG. 7 as an example, and a redundant description will be omitted below.

According to an embodiment, the button 401 may include a first stopper 418 (e.g., the first stopper 3151 of FIG. 6) or a second stopper 419 (e.g., the second stopper 3153 of FIG. 6).

According to an embodiment, the first stopper 418 may extend from the base 411 toward the second holder 453. For example, the first stopper 418 may extend or protrude from a portion of the base 411 corresponding to the first holder 451. At least a portion of the first stopper 418 may be inserted into the second holder 453. The first stopper 418 may have a rigid material. For example, the first stopper 418 may include stainless steel, but is not limited thereto.

According to an embodiment, the first stopper 418 may restrict and/or reduce excessive sagging of the base 411 when a pressure generated by the user is applied to the base 411.

According to an embodiment, the second stopper 419 may extend from the base 411 toward the third holder 455. For example, the second stopper 419 may extend or protrude from a portion of the base 411 corresponding to the first holder 451. At least a portion of the second stopper 419 may be inserted into the third holder 455. The second stopper 419 may have a rigid material. For example, the second stopper 419 may include stainless steel, but is not limited thereto.

According to an embodiment, the second stopper 419 may restrict and/or reduce excessive sagging of the base 411 when a pressure generated by the user is applied to the base 411.

According to an embodiment, the lateral surface 314 of the electronic device 101 and an outer surface (e.g., a surface facing the +X direction in FIG. 8) of the base 411 may form a substantially planar surface, but are not limited thereto. For example, the outer surface of the base 411 may be disposed to be not stepped with the lateral surface 314 of the electronic device 101.

FIG. 9 is a cross-sectional view illustrating an electronic device including a piezo actuator according to an embodiment of the disclosure.

The embodiment of FIG. 9 may be combined with the embodiments of FIGS. 1 to 8 or the embodiments of FIGS. 10 to 14.

Referring to FIG. 9, an electronic device 101 (e.g., the electronic device 101 of FIG. 1 or the electronic device 101 of FIGS. 2 to 5) may include a housing 301 (e.g., the housing 301 of FIGS. 4 to 5) or a key input device 400 (e.g., the volume key 316 of FIG. 4).

At least one of the components of the electronic device 101, the housing 301, and/or the key input device 400 of FIG. 9 may be the same as or similar to at least one of the components of the electronic device 101, the housing 301, and/or the key input device 400 described with reference to FIG. 6 as an example, and a redundant description will be omitted below.

According to an embodiment, the key input device 400 may include a support portion 407.

According to an embodiment, the support portion 407 may be configured to support at least a portion of the button 401. For example, the support portion 407 may be configured to support a portion of the button 401 (e.g., a portion 411a of the base 411) corresponding to the support portion 407. At least a part of the support portion 407 may be exposed to the outside of the first holder 451. The support portion 407 may have a rigid material. For example, the support portion 407 may include stainless steel, but is not limited thereto. The support portion 407 may be injection-molded with the first holder 451, but is not limited thereto.

According to an embodiment, the support portion 407 may include a first support portion 4071 or a second support portion 4072.

According to an embodiment, the first support portion 4071 may be at least partially inserted into the first holder 451. The second support portion 4072 may be coupled to an end of the first support portion 4071. The second support portion 4072 may extend in a direction (e.g., the Y-axis direction in FIG. 9) substantially perpendicular to a direction in which the first support portion 4071 extends (e.g., the X-axis direction in FIG. 9). The second support portion 4072 may extend, e.g., in a length direction (e.g., the Y-axis direction in FIG. 9) of the base 411 having an elongated shape. As the second support portion 4072 extends in the length direction of the base 411, an area in which the support portion 407 supports the base 411 may be increased. The second support portion 4072 may be spaced apart from the portion 411a of the base 411 corresponding to the second support portion 4072 by a specified gap or interval d in a state in which the user does not press the button 401. The interval d may be about 0.09 mm to about 0.10 mm, but is not limited thereto. The second support portion 4072 may be in contact with the portion 411a of the base 411 corresponding to the second support portion 4072 in a state in which the user presses the button 401 (e.g., a state in which the base 411 is moved or deformed). As the portion 411a of the base 411 is supported by the second support portion 4072, excessive deformation of the base 411 may be restricted and/or reduced. The piezo actuators 431 and 433 may be restricted and/or reduced from being excessively pressed or subjected to excessive stress by the first protruding portion 413 and/or the second protruding portion 415. Accordingly, damage to the piezo material of the piezo actuators 431 and 433 having a relatively weak material may be restricted and/or reduced.

FIGS. 10, 11, and 12 are cross-sectional views for describing an input sensor of a key input device according to an embodiment of the disclosure.

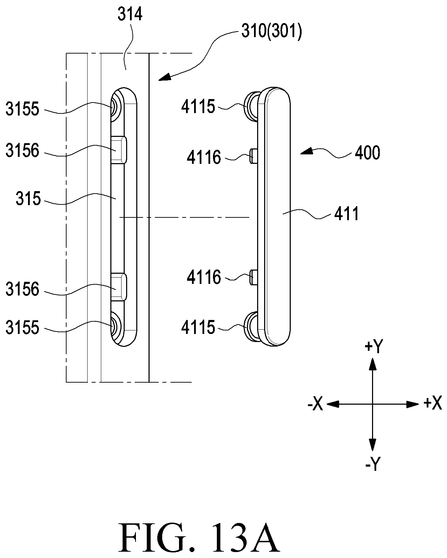

The embodiments of FIGS. 10 to 12 may be combined with the embodiments of FIGS. 1 to 9 or the embodiments of FIGS. 13A to 14.

Referring to FIGS. 10 to 12, a key input device 400 (e.g., the volume key 316 of FIG. 4 or the key input device 400 of FIGS. 6 to 9) may include an input sensor 408, 4081, or 4082 (e.g., the sensor module 176 of FIG. 1).

At least one of the components of the key input device 400 of FIGS. 10 to 12 may be the same as or similar to at least one of the components of the key input device 400 described with reference to FIGS. 6 to 9 as an example, and a redundant description will be omitted below.

Referring to FIG. 10, the key input device 400 may include the input sensor 408 for detecting a user pressing or touching the base 411. The input sensor 408 may be disposed on an inner surface (e.g., a surface facing the -X direction in FIG. 10) of the base 411. The input sensor 408 may include at least one of an ultrasonic sensor or a capacitive touch sensor. The input sensor 408 may be configured to detect a part of the user's body when the user presses or touches a portion of the base 411 corresponding to the first piezo actuator 431. When the input sensor 408 detects the part of the user's body, the electronic device (e.g., the electronic device 101 of FIGS. 6 to 9) may determine that the user has performed a key input through the key input device 400. The input sensor 408 may be positioned adjacent to the first protruding portion 413, but is not limited thereto.

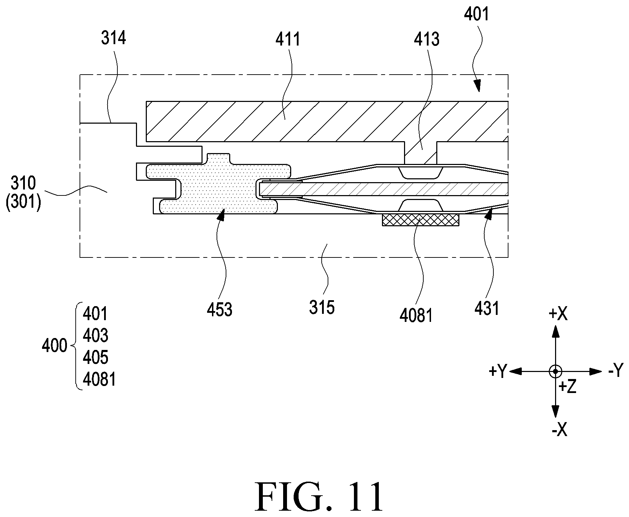

Referring to FIG. 11, the key input device 400 may include the input sensor 4081 for detecting a user pressing or touching the base 411. The input sensor 4081 may include a pressure sensor. The input sensor 4081 may be disposed on a part of the inner portion 315 corresponding to the first piezo actuator 431. For example, the input sensor 4081 may be inserted into a part of the inner portion 315. The input sensor 4081 may be pressed by the first piezo actuator 431 that is pressed by the first protruding portion 413 when the user presses or touches a portion of the base 411 corresponding to the first piezo actuator 431. When the input sensor 4081 detects the pressure by the first piezo actuator 431, the electronic device (e.g., the electronic device 101 of FIGS. 6 to 9) may determine that the user has performed a key input through the key input device 400.

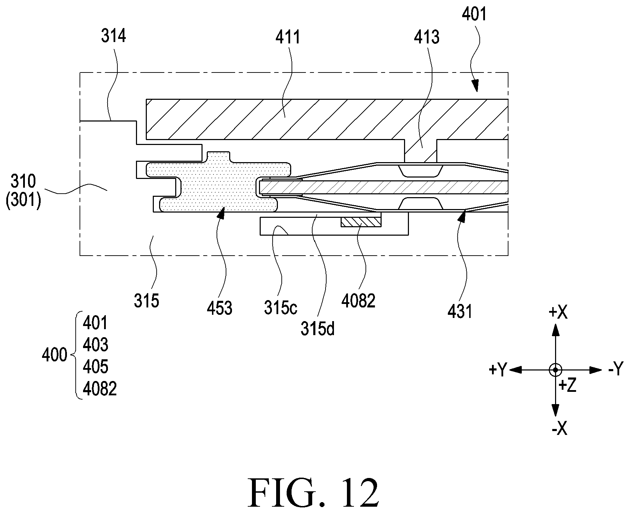

Referring to FIG. 12, the key input device 400 may include the input sensor 4082 for detecting a user pressing or touching the base 411. The input sensor 4082 may include a strain gage. The input sensor 4082 may be disposed on an extending portion 315d extending from at least a part of the inner portion 315. The extending portion 315d may be disposed in a groove 315c formed in the inner portion 315. At least a part of the extending portion 315d may be disposed adjacent to or in contact with the first piezo actuator 431. As the bottom surface of the groove 315c and the extending portion 315d are spaced apart from each other, the extending portion 315d may be at least partially bent. The extending portion 315d may be deformed to be bent by the first piezo actuator 431 that is pressed by the first protruding portion 413 when the user presses or touches a portion of the base 411 corresponding to the first piezo actuator 431. When the input sensor 4082 including the strain gage detects the deformation of the extending portion 315d, the electronic device (e.g., the electronic device 101 of FIGS. 6 to 9) may determine that the user has performed a key input through the key input device 400.

The input sensors 408, 4081, and 4082 described with reference to FIGS. 10 to 12 as an example may also be provided on the second piezo actuator (e.g., the second piezo actuator 433 of FIGS. 6 to 9) side.

According to an embodiment, when the electronic device (e.g., the electronic device 101 of FIGS. 6 to 9) detects a user's key input through the input sensor 408, 4081, or 4082, the electronic device may provide haptic feedback to the user by operating a piezo actuator corresponding to a portion of the base 411 touched by the user.

FIG. 13A is a view illustrating a state before a key input device is assembled to a housing according to an embodiment of the disclosure.

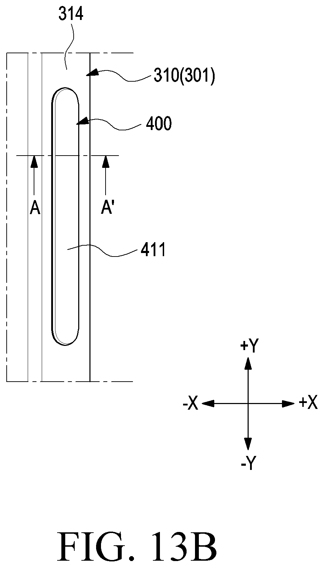

FIG. 13B is a view illustrating a state after a key input device is assembled to a housing according to an embodiment of the disclosure.

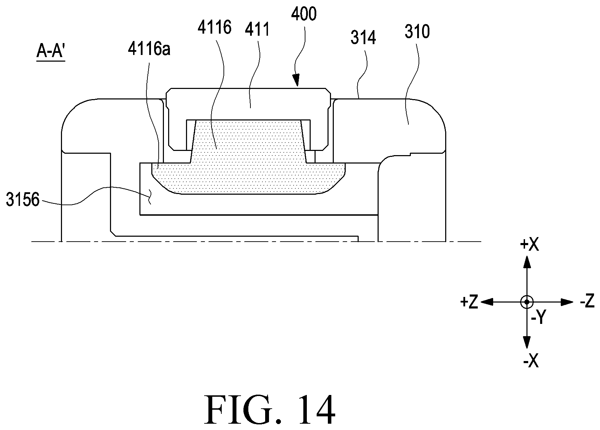

FIG. 14 is a cross-sectional view taken along line A-A' of FIG. 13B according to an embodiment of the disclosure.

The embodiments of FIGS. 13A to 14 may be combined with the embodiments of FIGS. 1 to 12.

At least one of the components of the housing 301 and/or the key input device 400 of FIGS. 13A to 14 may be the same as or similar to at least one of the components of the housing 301 and/or the key input device 400 described with reference to FIGS. 6 to 12 as an example, and a redundant description will be omitted below.

Referring to FIGS. 13A to 14, the key input device 400 may be accommodated in a groove or a recess formed in the side structure 310 of the housing 301 or the lateral surface 314 of the housing 301. For example, the key input device 400 may be disposed in the groove or the recess of the housing 301.

According to an embodiment, the key input device 400 may include a first fixing member 4115 or a second fixing member 4116. The first fixing member 4115 and the second fixing member 4116 may be disposed or formed on the base 411 of the button (e.g., the button 401 of FIGS. 6 to 12).

According to an embodiment, the first fixing member 4115 may be configured to be coupled to a first coupling portion 3155 formed in the inner portion 315 of the side structure 310. For example, the first fixing member 4115 may be hook-coupled to the first coupling portion 3155. The first coupling portion 3155 may include a groove, a recess, or a hole formed in the inner portion 315. The first fixing member 4115 may be provided as a pair respectively disposed at both ends of the base 411, but is not limited thereto. As the first fixing member 4115 is inserted into and fixed to the first coupling portion 3155, the base 411 may be restricted and/or reduced from being separated from the side structure 310 of the housing 301.

According to an embodiment, the second fixing member 4116 may be configured to be coupled to a second coupling portion 3156 formed in the inner portion 315 of the side structure 310. For example, the second fixing member 4116 may be hook-coupled to the second coupling portion 3156. The second coupling portion 3156 may include a groove, a recess, or a hole formed in the inner portion 315. The second fixing member 4116 may be disposed between the pair of first fixing members 4115, but is not limited thereto. The second fixing member 4116 may be provided as a pair, but is not limited thereto. As the second fixing member 4116 is inserted into and fixed to the second coupling portion 3156, the base 411 may be restricted and/or reduced from being separated from the side structure 310 of the housing 301.

According to an embodiment, in a state in which the key input device 400 is inserted into the groove or the recess of the housing 301 (e.g., FIG. 13B or FIG. 14), a portion of the second fixing member 4116 (e.g., 4116a of FIG. 14) may be configured to be inserted into the second coupling portion 3156 and to be caught by a part of the side structure 310. As the portion 4116a of the second fixing member 4116 is configured to be caught by the side structure 310, the base 411 coupled to the second fixing member 4116 may be restricted and/or reduced from being separated from the side structure 310.

The key input device 400 of the disclosure described with reference to FIGS. 6 to 14 as an example may be applied to an electronic device such as a smartphone, a tablet PC, an AR device, a VR device, a mixed reality (MR) device, a head mounted display (HMD) device, a smart watch, a smart ring, or a notebook, and may be applied to various portable electronic devices without being limited in form.

An electronic device may provide a technology that provides various feedback in order to provide an improved device use experience to a user. For example, the electronic device may provide visual feedback through a display, acoustic feedback through a speaker, or tactile feedback through a haptic module.

Recently, in order to provide tactile feedback to a user when the user inputs information using a button of an electronic device, a structure in which a button is associated with a haptic module has been proposed.

According to an embodiment of the disclosure, a piezo actuator capable of providing haptic feedback to a user and an electronic device including the same may be provided.

According to an embodiment of the disclosure, a support structure capable of supplementing the rigidity of a piezo actuator and an electronic device including the same may be provided.

However, the technical problem to be solved by the present disclosure is not limited to the above-mentioned problem, and may be variously determined within a range that does not depart from the spirit and scope of the present disclosure.

According to an embodiment of the disclosure, an electronic device capable of preventing and/or reducing damage to a piezo actuator while providing a coupling structure of the piezo actuator may be provided.

The effects obtainable from the present disclosure are not limited to the effects mentioned above, and other effects not mentioned will be clearly understood by those skilled in the art to which the present disclosure pertains from the following description.

According to an embodiment of the disclosure, an electronic device 101 may include a housing 301 including one surface 314.

According to an embodiment, the electronic device 101 may include a button 401 movably coupled to the one surface 314 with respect to the one surface 314 and separated from the one surface 314.

According to an embodiment, the electronic device 101 may include a first piezo actuator 431 disposed inside the button 401.

According to an embodiment, the electronic device 101 may include a second piezo actuator 433 disposed inside the button 401 and spaced apart from the first piezo actuator 431.

According to an embodiment, the electronic device 101 may include a first holder 451 coupled to the first piezo actuator 431 and the second piezo actuator 433.

According to an embodiment, the electronic device 101 may include a second holder 453 coupled to the first piezo actuator 431 and a portion of the housing 301.

According to an embodiment, the electronic device 101 may include a third holder 455 coupled to the second piezo actuator 433 and another portion of the housing 301.

According to an embodiment, the electronic device 101 may include a support portion 407 or 417 disposed at least partially between the button 401 and the first holder 451. The support portion 407 or 417 may be configured to support at least a portion of the button 401 corresponding to the support portion 407 or 417.

According to an embodiment, the button 401 may have an elongated shape when viewed from the outside of the electronic device 101. The first piezo actuator 431 and the second piezo actuator 433 may be arranged in parallel along the elongated direction of the button 401.

According to an embodiment, the support portion 407 or 417 may be disposed between the first piezo actuator 431 and the second piezo actuator 433.

According to an embodiment, the support portion 407 or 417 may be at least partially inserted into the first holder 451.

According to an embodiment, the support portion 407 may be in contact with the button 401 when the button 401 is pressed by a user. The support portion 407 may be spaced apart from the button 401 when the button 401 is not pressed by the user.

According to an embodiment, the support portion 417 may extend from the button 401 to the first holder 451.

According to an embodiment, the housing 301 may include a first stopper 3151 disposed between the second holder 453 and the button 401 and a second stopper 3153 disposed between the third holder 455 and the button 401.

According to an embodiment, the button 401 may include a first stopper 418 extending from the button 401 to the second holder 453 and a second stopper 419 extending from the button 401 to the third holder 455.

According to an embodiment, the support portion 407 may include a first support portion 4071 at least partially inserted into the first holder 451. The support portion 407 may include a second support portion 4072 disposed outside the first holder 451 and extending perpendicularly to the first support portion 4071.

According to an embodiment, the second support portion 4072 may be in contact with the button 401 when the button 401 is pressed by a user. The second support portion 4072 may be spaced apart from the button 401 when the button 401 is not pressed by the user.

According to an embodiment, the button 401 may include a base 411 exposed to the outside of the housing 301. The button 401 may include a first protruding portion 413 extending from the base 411 to the first piezo actuator 431. The button 401 may include a second protruding portion 415 extending from the base 411 to the second piezo actuator 433.

According to an embodiment, the support portion 407 or 417 may be configured to restrict deformation of the base 411 when the base 411 is pressed by a user.

According to an embodiment, each of the first piezo actuator 431 and the second piezo actuator 433 may include a piezo material 4315 including ceramic, a first disk 4311 disposed on one surface 314 of the piezo material, and a second disk 4313 disposed on the other surface of the piezo material.

According to an embodiment, the first disk 4311 may be configured to press the button 401.

According to an embodiment, each of the first holder 451, the second holder 453, and the third holder 455 may include a rubber material.

According to an embodiment of the disclosure, an electronic device 101 may include a housing 301 including one surface 314.

According to an embodiment, the electronic device 101 may include a button 401 movably coupled to the one surface 314 with respect to the one surface 314 and separated from the one surface 314.

According to an embodiment, the electronic device 101 may include a plurality of piezo actuators 403 disposed inside the button 401.

According to an embodiment, the electronic device 101 may include a first holder 451 disposed between the plurality of piezo actuators 403.

According to an embodiment, the electronic device 101 may include a support portion 407 or 417 disposed at least partially between the button 401 and the first holder 451.

According to an embodiment, the number of the plurality of piezo actuators 403 may be greater than the number of the buttons 401.

According to an embodiment, the button 401 may include a base 411 exposed to the outside of the electronic device 101. The button 401 may include a plurality of protruding portions 413 and 415 protruding from the base 411 and respectively in contact with the plurality of piezo actuators 403.

According to an embodiment, the support portion 407 or 417 may be disposed between the plurality of protruding portions 413 and 415.

According to an embodiment, the housing 301 may include an inner portion 315 configured to support the first holder 451 and an accommodating portion 315b formed in the inner portion 315.

According to an embodiment, the electronic device 101 may include an input sensor 408, 4081, or 4082 disposed inside the button 401 and configured to detect a user's key input.

The electronic device according to various embodiments disclosed in the present document may be one of various types of devices. The electronic device may include, e.g., a portable communication device (e.g., a smart phone), a computer device, a portable multimedia device, a portable medical device, a camera, a wearable device, or a home appliance device. The electronic device according to embodiments of the present document is not limited to the aforementioned devices.

The various embodiments of the present document and the terms used herein are not intended to limit the technical features described in the present document to specific embodiments, and should be understood to include various changes, equivalents, or replacements of the corresponding embodiments. In connection with the description of the drawings, similar reference numerals may be used for similar or related components. The singular form of a noun corresponding to an item may include one or more of the items, unless the relevant context clearly indicates otherwise. In the present document, each of the phrases such as "A or B," "at least one of A and B," "at least one of A or B," "A, B or C," "at least one of A, B and C," and "at least one of A, B, or C" may include any one of the items listed together in the corresponding phrase, or all possible combinations thereof. Terms such as "first" or "second" may be used merely to distinguish a corresponding component from another corresponding component, and do not limit the corresponding components in another aspect (e.g., importance or order). When a (e.g., first) component is referred to as being "coupled" or "connected" to another (e.g., second) component, with or without the term "functionally" or "communicatively," it means that the certain component may be connected to the other component directly (e.g., by wire), wirelessly, or through a third component.

The term "module" used in various embodiments of the present document may include a unit implemented in hardware, software, or firmware, and may be used interchangeably with terms such as logic, logic block, component, or circuit. A module may be an integrally configured component or a minimum unit or a part thereof of the component performing one or more functions. For example, according to an embodiment, the module may be implemented in the form of an application-specific integrated circuit (ASIC).

The various embodiments of the present document may be implemented as software (e.g., the program 140) including one or more instructions stored in a storage medium (e.g., the internal memory 136 or the external memory 138) readable by a machine (e.g., the electronic device 101). For example, a processor (e.g., the processor 120) of the machine (e.g., the electronic device 101) may invoke at least one of the one or more instructions stored from the storage medium and execute it. This makes it possible for the machine to be operated to perform at least one function according to the at least one invoked instruction. The one or more instructions may include code generated by a compiler or code that may be executed by an interpreter. The machine-readable storage medium may be provided in the form of a non-transitory storage medium. Here, "non-transitory" merely means that the storage medium is a tangible device and does not include a signal (e.g., an electromagnetic wave), and this term does not distinguish between a case where data is stored semi-permanently in the storage medium and a case where data is temporarily stored.

According to an embodiment, the method according to an embodiment disclosed in the present document may be provided by being included in a computer program product. The computer program product may be traded as a commodity between a seller and a buyer. The computer program product may be distributed in the form of a machine-readable storage medium (e.g., a compact disc read only memory (CD-ROM)), or distributed (e.g., downloaded or uploaded) online through an application store (e.g., Play Store^{™}) or directly between two user devices (e.g., smart phones). In the case of online distribution, at least a part of the computer program product may be at least temporarily stored or temporarily generated in a machine-readable storage medium such as memory of a manufacturer's server, a server of an application store, or a relay server.

According to various embodiments, each component (e.g., a module or a program) of the aforementioned components may include a single entity or a plurality of entities, and some of the plurality of entities may be separately disposed in another component. According to various embodiments, one or more of the aforementioned components or operations may be omitted, or one or more other components or operations may be added. Alternatively or additionally, a plurality of components (e.g., modules or programs) may be integrated into one component. In this case, the integrated component may perform one or more functions of each component of the plurality of components in the same or similar manner as performed by a corresponding component among the plurality of components prior to the integration. According to various embodiments, operations performed by a module, a program, or another component may be executed sequentially, in parallel, repeatedly, or heuristically, or one or more of the operations may be executed in a different order or omitted, or one or more other operations may be added.

While specific embodiments have been described in the detailed description of the disclosure, it will be apparent to those of ordinary skill in the art that various modifications may be made without departing from the scope of the disclosure.

## Claims

1. An electronic device (101) comprising:
a housing (301) including one surface (314);
a button (401) movably coupled to the one surface (314) with respect to the one surface (314) and separated from the one surface (314);
a first piezo actuator (431) disposed inside the button (401);
a second piezo actuator (433) disposed inside the button (401) and spaced apart from the first piezo actuator (431);
a first holder (451) coupled to the first piezo actuator (431) and the second piezo actuator (433);
a second holder (453) coupled to the first piezo actuator (431) and a portion of the housing (301);
a third holder (455) coupled to the second piezo actuator (433) and another portion of the housing (301); and
a support portion (407, 417) disposed at least partially between the button (401) and the first holder (451), the support portion (407, 417) configured to support at least a portion of the button (401) corresponding to the support portion (407, 417).

2. The electronic device of claim 1,
wherein the button (401) has an elongated shape when viewed from outside the electronic device (101), and
the first piezo actuator (431) and the second piezo actuator (433) are disposed in parallel along an elongated direction of the button (401).

3. The electronic device of any one of claims 1 and 2,
wherein the support portion (407, 417) is disposed between the first piezo actuator (431) and the second piezo actuator (433).

4. The electronic device of any one of claims 1 to 3,
wherein the support portion (407, 417) is at least partially inserted into the first holder (451).

5. The electronic device of any one of claims 1 to 4,
wherein the support portion (407) is in contact with the button (401) when the button (401) is pressed by a user, and
the support portion (407) is spaced apart from the button (401) when the button (401) is not pressed by the user.

6. The electronic device of any one of claims 1 to 5,
wherein the support portion (417) extends from the button (401) to the first holder (451).

7. The electronic device of claim 1,
wherein the housing (301) further includes a first stopper (3151) disposed between the second holder (453) and the button (401) and a second stopper (3153) disposed between the third holder (455) and the button (401).

8. The electronic device of any one of claims 1 to 7,
wherein the button (401) includes a first stopper (418) extending from the button (401) to the second holder (453) and a second stopper (419) extending from the button (401) to the third holder (455).

9. The electronic device of any one of claims 1 to 8, wherein the support portion (407) comprises:
a first support portion (4071) at least partially inserted into the first holder (451); and
a second support portion (4072) disposed outside the first holder (451) and extending perpendicularly to the first support portion (4071).

10. The electronic device of any one of claims 1 to 9,
wherein the second support portion (4072) is in contact with the button (401) when the button (401) is pressed by a user, and
the second support portion (4072) is spaced apart from the button (401) when the button (401) is not pressed by the user.

11. The electronic device of any one of claims 1 to 10, wherein the button (401) comprises:
a base (411) exposed to outside of the housing (301);
a first protruding portion (413) extending from the base (411) to the first piezo actuator (431); and
a second protruding portion (415) extending from the base (411) to the second piezo actuator (433).

12. The electronic device of any one of claims 1 to 11,
wherein the support portion (407, 417) is configured to restrict deformation of the base (411) when the base (411) is pressed by a user.

13. The electronic device of any one of claims 1 to 12,
wherein each of the first piezo actuator (431) and the second piezo actuator (433) comprises:
a piezo material (4315) including ceramic;
a first disk (4311) disposed on one surface (314) of the piezo material; and
a second disk (4313) disposed on the other surface of the piezo material.

14. The electronic device of any one of claims 1 to 13,
wherein the first disk (4311) is configured to press the button (401).

15. The electronic device of any one of claims 1 to 14,
wherein each of the first holder (451), the second holder (453), and the third holder (455) includes a rubber material.
